# FASCICULE DE BREVET EUROPEEN

(11) **EP 3 864 386 B1**
(45) Date de publication et mention de la délivrance du brevet: **28.09.2022**
(21) Numéro de dépôt: 19813616.0
(22) Date de dépôt: 10.10.2019
(51) Int. Cl.: G01J 5/02, B81C 1/00, G01J 5/20

(54) **PROCEDE DE FABRICATION D'UN DISPOSITIF DE DETECTION D'UN RAYONNEMENT ELECTROMAGNETIQUE COMPORTANT UN ELEMENT DE DETECTION SUSPENDU**
VERFAHREN ZUR HERSTELLUNG EINER VORRICHTUNG ZUR DETEKTION ELEKTROMAGNETISCHER STRAHLUNG MIT EINEM HÄNGENDEN DETEKTIONSELEMENT
PROCESS FOR MANUFACTURING A DEVICE FOR DETECTING ELECTROMAGNETIC RADIATION, COMPRISING A SUSPENDED DETECTION ELEMENT

(30) Priorité: 12.10.2018 FR 1859482
(43) Date de publication de la demande: 18.08.2021
(73) Titulaire: COMMISSARIAT À L'ÉNERGIE ATOMIQUE ET AUX ÉNERGIES ALTERNATIVES, 75015 Paris (FR)
(72) Inventeur: BECKER, Sébastien, 38054 GRENOBLE Cedex 09 (FR); YON, Jean-Jacques, 38054 GRENOBLE Cedex 09 (FR)
(74) Mandataire: INNOV-GROUP
(86) Numéro de dépôt international: PCT/FR2019/052416
(87) Numéro de publication internationale: WO 2020/074838

(56) Documents cités:
- EP-A1- 1 041 371
- EP-A1- 1 637 853
- WO-A2-2014/143299
- US-A1- 2002 179 837
- US-A1- 2004 140 428
- US-A1- 2004 200 962

## Description

### DOMAINE TECHNIQUE

Le domaine de l'invention est celui des procédés de fabrication des dispositifs de détection de rayonnement électromagnétique comportant au moins un détecteur thermique reposant sur un substrat. Le détecteur thermique comporte au moins un élément de détection suspendu par au moins un pilier de maintien, et est réalisé au moyen de plusieurs couches sacrificielles disposées sur le substrat et empilées les unes sur les autres. L'invention s'applique notamment au domaine de l'imagerie infrarouge ou térahertz, de la thermographie, voire de la détection de gaz.

### ÉTAT DE LA TECHNIQUE ANTÉRIEURE

Un dispositif de détection de rayonnement électromagnétique peut comporter des pixels sensibles formés chacun d'un détecteur thermique comportant une membrane absorbante thermiquement isolée du substrat de lecture. La membrane absorbante comporte un absorbeur du rayonnement électromagnétique à détecter associé thermiquement à un transducteur thermométrique dont une propriété électrique varie en intensité en fonction de l'échauffement du transducteur.

La température du transducteur thermométrique étant cependant grandement dépendante de son environnement, la membrane absorbante est isolée thermiquement du substrat et du circuit de lecture, celui-ci étant disposé dans le substrat. Ainsi, la membrane absorbante est généralement suspendue au-dessus du substrat par des piliers d'ancrage 21, et en est isolée thermiquement par des bras d'isolation thermique. Ces piliers d'ancrage 21 et bras d'isolation thermique présentent également une fonction électrique en assurant la connexion électrique de la membrane absorbante au circuit de lecture.

On cherche, d'une manière générale, à diminuer le pas pixel tout en optimisant les performances des détecteurs thermiques. Pour cela, une approche consiste à réaliser un détecteur thermique comportant une structure tridimensionnelle suspendue au-dessus du substrat de lecture 10, et ayant plusieurs étages fonctionnels distincts et superposés les uns aux autres.

Ainsi, le document WO2009/026505 décrit un exemple d'un tel détecteur thermique comportant un réflecteur situé sur et au contact du substrat de lecture 10, et une structure tridimensionnelle suspendue au-dessus du substrat de lecture par les piliers d'ancrage 21. La structure tridimensionnelle comporte un premier étage dans lequel s'étendent les bras d'isolation thermique ainsi que la membrane contenant le transducteur thermométrique, ici un matériau thermistance, et un deuxième étage comportant un absorbeur du rayonnement électromagnétique à détecter. Un pilier de maintien assure à la fois le maintien de l'absorbeur au-dessus de la membrane à thermistance ainsi que la liaison thermique entre ces deux éléments. L'absorbeur et le réflecteur forment ensemble une cavité optique renforçant l'absorption du rayonnement électromagnétique. Par ailleurs, des échancrures, éventuellement traversantes sont prévues dans la couche absorbante, de manière à réduire la masse thermique du détecteur thermique.

Par ailleurs, l'article de Li et al. intitulé Recent development of ultra small pixel uncooled focal plane array at DRS, Proc. SPIE 2007, Vol.6542, p.1Y.1-1Y.12, décrit un détecteur thermique similaire à celui décrit précédemment, dans lequel l'absorbeur et le pilier de maintien semblent être réalisés d'un seul tenant et en un même matériau. Cet absorbeur comporte ainsi une portion périphérique supérieure qui s'étend de manière planaire autour d'une portion centrale verticale creuse, celle-ci reposant sur la membrane à thermistance.

Par ailleurs, il est connu de réaliser un dispositif de détection comportant des détecteurs thermiques dans le cadre d'un procédé dit *above IC,* c'est-à-dire par un procédé comportant une séquence continue d'opérations de réalisation microélectronique (dépôt, photolithographie et gravure) effectuées sur un unique substrat de lecture. Les détecteurs thermiques sont ainsi réalisés au moyen de différentes couches sacrificielles déposées sur le substrat de lecture et empilées les unes sur les autres, puis supprimées *in fine* pour assurer la suspension de la membrane contenant le transducteur thermométrique au-dessus du substrat. Un exemple d'un tel procédé de fabrication est notamment décrit dans la demande de brevet EP2743659.

Il existe un besoin de disposer d'un procédé de fabrication d'un dispositif de détection amélioré, dont le ou les détecteurs thermiques comportent un élément de détection (absorbeur...) suspendu au-dessus du substrat par au moins un pilier de maintien, réalisés au moyen de couches sacrificielles déposées sur le substrat et empilées les unes sur les autres.

### EXPOSÉ DE L'INVENTION

L'invention a pour objectif de remédier au moins en partie aux inconvénients de l'art antérieur, et plus particulièrement de proposer un procédé de fabrication d'un dispositif de détection d'un rayonnement électromagnétique qui présente des performances optimisées tout en autorisant une réduction des dimensions latérales du pixel sensible.

Pour cela, l'objet de l'invention est un procédé de fabrication d'un dispositif de détection d'un rayonnement électromagnétique, le dispositif de détection comportant : un substrat comportant un circuit de lecture ; au moins un détecteur thermique reposant sur le substrat, et connecté au circuit de lecture, comportant un élément de détection suspendu au-dessus du substrat par au moins un pilier de maintien. Le procédé de fabrication comporte les étapes suivantes :
o dépôt, sur le substrat, d'une première couche sacrificielle ;
o réalisation, sur la première couche sacrificielle, d'au moins un plot intermédiaire destiné à former un ergot, le plot intermédiaire étant réalisé en au moins un matériau sensible à un agent de gravure chimique utilisé ultérieurement lors de la gravure de couches sacrificielles ;
o dépôt, sur la première couche sacrificielle et le plot intermédiaire, d'une deuxième couche sacrificielle ;
∘ réalisation, par gravure localisée des première et deuxième couches sacrificielles, d'au moins un orifice vertical délimité transversalement par une bordure latérale, positionné de sorte qu'une portion du plot intermédiaire soit en saillie dans l'orifice vertical, formant ainsi un ergot ;
∘ dépôt conforme, sur la bordure latérale de l'orifice vertical, d'une couche d'intérêt destinée à former le pilier de maintien, laquelle définit alors un espace interne vide du pilier de maintien, l'ergot entraînant une rupture locale de continuité de la couche d'intérêt, formant une ouverture latérale traversante du pilier de maintien ;
∘ dépôt d'une couche sacrificielle de remplissage, de manière à remplir l'espace interne vide du pilier de maintien ;
∘ réalisation, sur la deuxième couche sacrificielle et la couche sacrificielle de remplissage, de l'élément de détection qui repose sur et au contact du pilier de maintien ;
∘ suspension de l'élément de détection, par gravure desdites couches sacrificielles et du plot intermédiaire par ledit agent de gravure, la couche sacrificielle de remplissage étant alors gravée au travers de l'ouverture latérale traversante.

Certains aspects préférés mais non limitatifs de ce procédé de fabrication sont les suivants.

L'espace interne du pilier de maintien peut déboucher sur une ouverture supérieure située de manière opposée au substrat, ladite ouverture supérieure étant obturée par l'élément de détection.

La couche d'intérêt peut présenter, au niveau de la bordure latérale de l'orifice vertical, une épaisseur moyenne, l'ergot présentant une saillie vis-à-vis de la bordure latérale d'une distance au moins égale à ladite épaisseur moyenne.

Le plot intermédiaire peut être réalisé en un matériau choisi parmi le Ti, le Ta2O5, et un nitrure de silicium.

La couche d'intérêt peut être déposée par dépôt chimique en phase vapeur.

La couche d'intérêt peut être réalisée en un matériau choisi parmi le WSi, le TiN et le TiW.

Les couches sacrificielles peuvent être réalisées en un matériau minéral, et être supprimées par gravure chimique humide en milieu acide.

A la suite de l'étape de dépôt de la couche sacrificielle de remplissage, celle-ci peut comporter une portion supérieure qui recouvre une partie périphérique de la couche d'intérêt qui recouvre une face supérieure de la deuxième couche sacrificielle autour de l'orifice vertical, et une portion inférieure qui remplit l'espace interne du pilier de maintien.

Le procédé peut comporter une étape de suppression de la portion supérieure de la couche sacrificielle de remplissage, de sorte que la portion inférieure affleure au niveau de la partie périphérique de la couche d'intérêt.

L'élément de détection peut être un absorbeur du rayonnement électromagnétique à détecter, le pilier de maintien reposant sur et au contact d'une membrane comportant un transducteur thermométrique et suspendue au-dessus du substrat par des bras d'isolation thermique, un réflecteur reposant sur et au contact du substrat.

L'élément de détection peut être une membrane absorbante du rayonnement électromagnétique à détecter et comportant un transducteur thermométrique, le pilier de maintien reposant sur et au contact d'un bras d'isolation thermique suspendu au-dessus du substrat par un pilier d'ancrage, un réflecteur étant disposé entre la membrane absorbante et le bras d'isolation thermique.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1I illustrent différentes étapes d'un procédé de fabrication d'un dispositif de détection selon un premier mode de réalisation, dans lequel l'élément de détection est un absorbeur du détecteur thermique ;
les figures 2A à 2H illustrent différentes étapes d'un procédé de fabrication d'un dispositif de détection selon un deuxième mode de réalisation, dans lequel l'élément de détection est une membrane absorbante à thermistance du détecteur thermique.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, l'expression « comportant un » doit être comprise, sauf indication contraire, comme « comportant au moins un » et non pas comme « comportant un unique ».

L'invention porte sur un procédé de fabrication d'un dispositif de détection d'un rayonnement électromagnétique, par exemple un rayonnement infrarouge ou térahertz. Le dispositif de détection peut ainsi être particulièrement adapté à détecter un rayonnement infrarouge de la gamme LWIR *(Long Wavelength Infrared,* en anglais) dont la longueur d'onde est comprise entre 8µm et 14µm environ.

Le dispositif de détection comporte un ou plusieurs détecteurs thermiques, et de préférence une matrice de détecteurs thermiques identiques, qui reposent sur un substrat et sont connectés à un circuit de lecture situé dans le substrat. Les détecteurs thermiques forment ainsi des pixels sensibles agencés périodiquement, et peuvent présenter une dimension latérale dans le plan du substrat (dite pas pixel), de l'ordre de quelques dizaines de microns, par exemple égale à 10µm environ voire moins.

Selon l'invention, le ou les détecteurs thermiques comportent chacun un élément de détection suspendu au-dessus du substrat par au moins un pilier de maintien creux. L'élément de détection participe à détecter le rayonnement électromagnétique d'intérêt. Il peut ainsi s'agir, selon un premier mode de réalisation, d'un absorbeur du rayonnement électromagnétique à détecter maintenu au-dessus d'une membrane comportant un transducteur thermométrique, voire, selon un deuxième mode de réalisation, de la membrane comportant le transducteur thermométrique. Ces différents modes de réalisation sont décrits en détail par la suite à titre illustratif, et d'autres configurations sont possibles.

Par ailleurs, le détecteur thermique comporte avantageusement une structure tridimensionnelle, suspendue au-dessus du substrat par les piliers d'ancrage, et comportant plusieurs étages fonctionnels distincts et superposés les uns aux autres, c'est-à-dire disposés en regard et parallèlement les uns des autres. L'élément de détection et le pilier de maintien, comme le transducteur thermométrique et l'absorbeur, sont de préférence disposés dans les différents étages de la structure tridimensionnelle.

L'invention s'applique ainsi en particulier aux détecteurs thermiques comportant un transducteur thermométrique, suspendu au-dessus du substrat par des piliers d'ancrage 21 et thermiquement isolé de celui-ci par des bras d'isolation thermique. Les piliers d'ancrage 21 et les bras d'isolation thermique assurent également la connexion du transducteur thermométrique au circuit de lecture. D'une manière générale, un transducteur thermométrique est un élément présentant une propriété électrique variant avec son échauffement, et peut être un matériau thermistance formée par exemple d'oxyde de vanadium ou de titane, ou de silicium amorphe, une capacité formée par un matériau pyroélectrique ou ferroélectrique, une diode (jonction pn ou pin), voire un transistor à effet de champ et à structure métal - oxyde - semiconducteur (MOSFET).

De plus, de tels détecteurs thermiques comportent chacun un absorbeur du rayonnement électromagnétique à détecter, disposé en liaison thermique avec le transducteur thermométrique. Les détecteurs thermiques comportent également chacun, de préférence, un réflecteur agencé vis-à-vis de l'absorbeur de manière à former une cavité interférentielle quart d'onde, permettant ainsi de maximiser l'absorption du rayonnement électromagnétique à détecter par l'absorbeur.

Par ailleurs, selon l'invention, le ou les détecteurs thermiques sont réalisés au moyen de différentes couches sacrificielles déposées sur le substrat et empilées les unes sur les autres, lesquelles sont ensuite supprimées au moyen d'un agent de gravure chimique de manière à obtenir notamment la suspension de l'élément de détection, et avantageusement de la structure tridimensionnelle. Selon l'invention, le pilier de maintien est alors creux et comporte une ouverture latérale traversante (i.e. non obturée) permettant l'évacuation d'une portion d'une couche sacrificielle de remplissage située alors dans l'espace interne du pilier de maintien. Un tel procédé de fabrication permet ainsi de réduire la masse thermique du pilier de maintien, et donc d'optimiser la constante de temps thermique associée au détecteur thermique. Les performances du dispositif de détection sont donc améliorées. Ceci est particulièrement avantageux dans le cas où, pour réaliser un détecteur thermique à pas pixel réduit, l'espace interne du pilier de maintien débouche sur une ouverture supérieure, suivant l'axe Z, laquelle étant obturée par exemple par l'élément de détection.

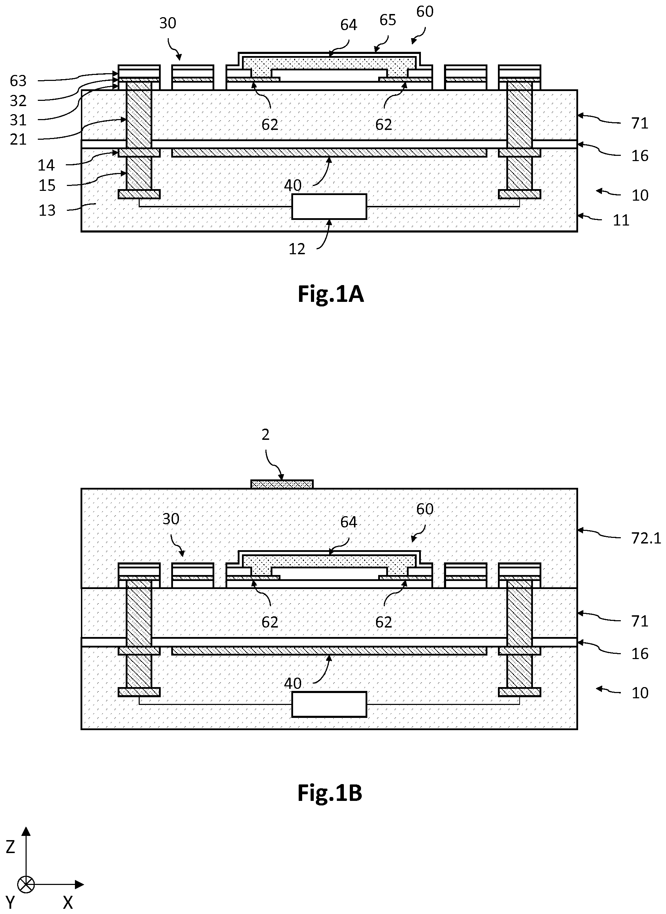

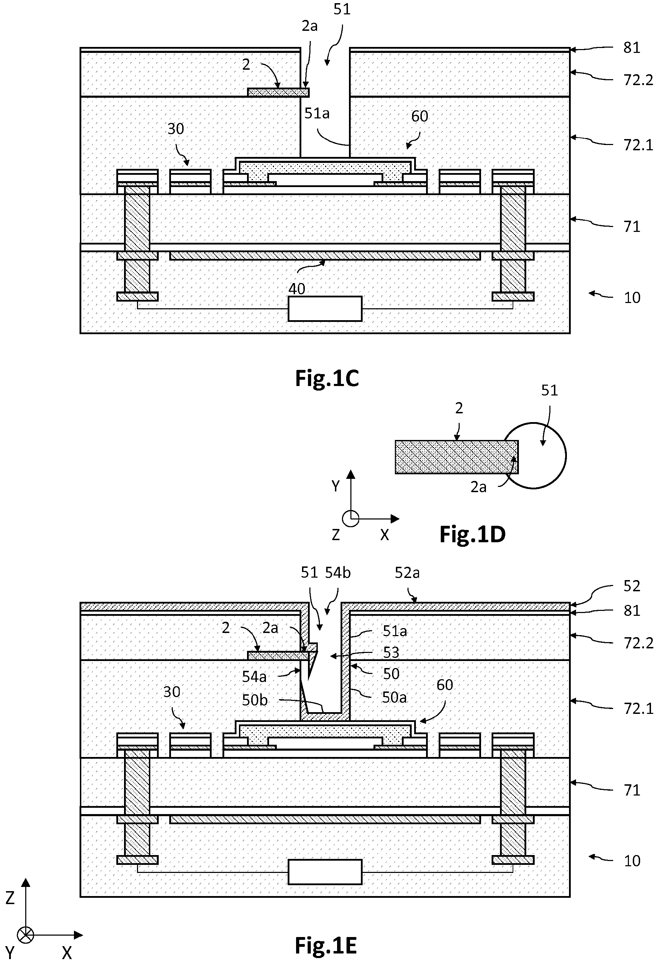

Les figures 1A à 1I illustrent différentes étapes d'un procédé de fabrication du dispositif de détection 1 selon un premier mode de réalisation. Un seul détecteur thermique 20 est ici représenté, mais le dispositif de détection 1 comporte avantageusement une matrice de détecteurs thermiques 20 identiques (pixels sensibles). Dans cet exemple, l'élément de détection correspond à l'absorbeur 80 du détecteur thermique 20. Il est maintenu au-dessus d'une membrane 60 contenant le transducteur thermométrique 64, ici un matériau thermistance tel que du silicium amorphe ou un oxyde de vanadium, par au moins un pilier de maintien 50.

Par ailleurs, chaque détecteur thermique 20 comporte ici une structure tridimensionnelle, suspendue au-dessus du substrat de lecture 10 par des piliers d'ancrage 21, comportant deux étages fonctionnels distincts et superposés l'un à l'autre. Dans un premier étage inférieur s'étendent de manière sensiblement plane les bras d'isolation thermique 30 et la membrane 60 à thermistance. Dans un deuxième étage supérieur s'étend de manière sensiblement plane l'élément de détection, ici l'absorbeur 80, suspendu au-dessus de la membrane 60 à thermistance par le pilier de maintien 50. Celui-ci assure alors une liaison thermique entre l'absorbeur 80 et la thermistance 64. Le réflecteur 40 est ici formé d'une couche plane reposant sur et au contact du substrat de lecture 10.

De plus, chaque détecteur thermique 20 est ici réalisé en utilisant des couches sacrificielles minérales déposées sur le substrat de lecture 10 et empilées les unes sur les autres, ces couches sacrificielles étant destinées à être ultérieurement supprimées par gravure chimique humide en milieu acide, par exemple à l'acide fluorhydrique (HF) en phase vapeur.

On définit ici et pour la suite de la description un repère direct tridimensionnel orthogonal (X,Y,Z), où le plan (X,Y) est sensiblement parallèle au plan principal du substrat du dispositif de détection 1, et où l'axe Z est orienté suivant une direction sensiblement orthogonale au plan principal du substrat de lecture 10 et orientée vers l'élément de détection. Dans la suite de la description, les termes « inférieur » et « supérieur » s'entendent comme étant relatifs à un positionnement croissant lorsqu'on s'éloigne du substrat suivant la direction +Z.

En référence à la fig.1A, on réalise tout d'abord un support à l'élément de détection (absorbeur) et au pilier de maintien. Il s'agit ici de l'étage fonctionnel inférieur de la structure tridimensionnelle du détecteur thermique. Pour cela, on réalise tout d'abord le substrat de lecture 10, réalisé dans cet exemple à base de silicium, formé d'un substrat support 11 contenant le circuit de lecture 12 adapté à commander et lire le détecteur thermique.

Le circuit de lecture 12 se présente ici sous la forme d'un circuit intégré CMOS situé dans un substrat support 11. Il comporte des portions 14 de lignes conductrices, par exemple métalliques, séparées les unes des autres par des couches isolantes inter-métal 13 réalisées en un matériau diélectrique 13, par exemple un matériau minéral à base de silicium tel qu'un oxyde de silicium SiOₓ, un nitrure de silicium SiNₓ, ou leurs alliages. Il peut également comporter des éléments électroniques actifs ou passifs (non représentés), par exemple des diodes, transistors, condensateurs, résistances..., connectés par des interconnexions électriques au détecteur thermique d'une part, et à un plot de connexion (non représenté) d'autre part, ce dernier étant destiné à connecter le dispositif de détection 1 à un dispositif électronique externe.

A titre illustratif, les portions conductrices 14 et les vias conducteurs 15 peuvent être réalisés, par exemple, en cuivre, en aluminium ou en tungstène par exemple au moyen d'un procédé damascène dans lequel on remplit des tranchées réalisées dans la couche isolante inter-métal 13. Le cuivre ou le tungstène peut éventuellement être situé entre des sous-couches en nitrure de titane ou autre. L'affleurement des portions conductrices 14 au niveau d'une face supérieure du substrat de lecture 10 peut être obtenu par une technique de planarisation mécano-chimique (CMP).

On réalise également le réflecteur 40 du détecteur thermique 20. Le réflecteur 40 est ici formé par une portion 14 d'une ligne conductrice du dernier niveau d'interconnexion, celle-ci étant réalisée en un matériau adapté à réfléchir le rayonnement électromagnétique à détecter. Il s'étend en regard de la membrane 60 à thermistance, et est destiné à former avec l'absorbeur une cavité interférentielle quart d'onde vis-à-vis du rayonnement électromagnétique à détecter.

On dépose ensuite une couche de protection 16 de manière à recouvrir la couche isolante inter-métal 13, les portions conductrices 14, et ici le réflecteur 40. Cette couche de protection 16 correspond ici à une couche d'arrêt de gravure réalisée en un matériau sensiblement inerte à l'agent de gravure chimique utilisé ultérieurement pour supprimer les couches sacrificielles minérales, par exemple au milieu HF en phase vapeur. Cette couche de protection 16 forme ainsi une couche hermétique et chimiquement inerte. Elle est électriquement isolante pour éviter tout court-circuit entre les portions conductrices 14. Elle permet ainsi d'éviter que les couches isolantes minérales sous-jacentes 13 ne soient gravées lors de cette étape de suppression des couches sacrificielles. Elle peut être formée en un oxyde ou nitrure d'aluminium, en nitrure ou trifluorure d'aluminium, ou en silicium amorphe non intentionnellement dopé. Elle peut être déposée par exemple par PVD (pour *Physical Vapor Deposition,* en anglais) et peut présenter une épaisseur de l'ordre d'une dizaine de nanomètres à quelques centaines de nanomètres, par exemple comprise entre 10nm et 500nm, de préférence comprise entre 20nm et 100nm.

On réalise ensuite les piliers d'ancrage 21. Pour cela, on dépose tout d'abord une première couche sacrificielle inférieure 71 sur le substrat de lecture 10, par exemple réalisée en un matériau minéral tel qu'un oxyde de silicium SiOₓ déposé par dépôt chimique en phase vapeur assisté par plasma (PECVD). Ce matériau minéral est apte à être supprimé par gravure chimique humide, en particulier par attaque chimique en milieu acide, l'agent de gravure étant de préférence de l'acide fluorhydrique (HF) en phase vapeur. Cette couche sacrificielle minérale 71 est déposée de manière à s'étendre continûment sur sensiblement toute la surface du substrat de lecture 10 et recouvrir ainsi la couche de protection 16. L'épaisseur de la couche sacrificielle 71 suivant l'axe Z peut être de l'ordre de quelques centaines de nanomètres à quelques microns.

On réalise ensuite les piliers d'ancrage 21 dans des orifices verticaux pratiqués préalablement au travers de la couche sacrificielle 71 et de la couche de protection 16. Ils peuvent être réalisés par remplissage des orifices verticaux par un ou plusieurs matériaux électriquement conducteurs. A titre d'exemple, ils peuvent comporter chacun une couche de TiN déposé par PVD ou MOCVD (pour *Metal Organic Chemical Vapor Deposition,* en anglais) sur la bordure latérale et le fond des orifices verticaux, et un cœur électriquement conducteur en cuivre ou en tungstène remplissant l'espace délimité transversalement par la couche de TiN. Une étape de planarisation mécano-chimique (CMP) permet ensuite d'éliminer les matériaux de remplissage en excès et de planariser la face supérieure formée par la couche sacrificielle 71 et les piliers d'ancrage 21. Les piliers d'ancrage 21 forment donc des plots conducteurs réalisés en au moins un matériau électriquement conducteur, qui s'étendent suivant l'axe Z à partir du substrat de lecture 10 jusqu'aux bras d'isolation thermique 30. Ils sont au contact des portions conductrices 14, et assurent ainsi la connexion électrique du détecteur thermique 20 au circuit de lecture 12.

On réalise ensuite les bras d'isolation thermique 30 et la membrane 60 comportant le matériau thermistance 64. Les bras d'isolation thermique 30 assurent l'isolation thermique de la membrane 60 à thermistance vis-à-vis du substrat de lecture 10, la connexion électrique du matériau thermistance 64, et participent à maintenir la membrane 60 à thermistance suspendue au-dessus du substrat de lecture 10. Pour cela, on dépose ici une couche diélectrique inférieure 31 sur la couche sacrificielle 71, puis une couche conductrice 32 et une couche diélectrique intermédiaire 63. Le contact électrique entre le pilier d'ancrage 21 et la couche conductrice 32 est obtenu par une ouverture pratiquée au préalable au travers de la couche diélectrique inférieure 31 et remplie par le matériau de la couche conductrice 32. La couche conductrice 32 est ainsi en contact avec l'extrémité supérieure des piliers d'ancrage 21. Elle est réalisée en un matériau électriquement conducteur, par exemple du TiN d'une épaisseur de quelques nanomètres à quelques dizaines de nanomètres, par exemple 10nm. Les couches diélectriques inférieure 31 et intermédiaire 63 peuvent être réalisées en silicium amorphe, carbure de silicium, alumine Al₂O₃ ou nitrure d'aluminium, entre autres. Elles peuvent présenter une épaisseur de quelques dizaines de nanomètres, par exemple 20nm, et participent à assurer la rigidification des bras d'isolation thermique 30.

La membrane 60 à thermistance est formée d'un empilement ici de la couche isolante inférieure 31, de deux électrodes 62 issues de la couche conductrice 32 et isolées l'une de l'autre par un espacement latéral, de la couche isolante intermédiaire 63 recouvrant les électrodes 62 et l'espacement latéral, hormis en deux ouvertures débouchant sur les électrodes 62, d'un matériau thermistance 64, par exemple du silicium amorphe ou un oxyde de vanadium ou de titane. Le matériau thermistance 64 est au contact des deux électrodes 62 via les ouvertures. Une couche supérieure de protection 65 est ensuite déposée de manière à recouvrir le matériau thermistance 64 et éventuellement la couche diélectrique intermédiaire 63 au niveau des bras d'isolation thermique 30. Elle permet de protéger le matériau thermistance 64 vis-à-vis de l'agent de gravure chimique utilisé lors de la suppression ultérieure des couches sacrificielles minérales. Une structuration des couches diélectriques 31, 63, de la couche conductrice 32, et de la couche supérieure de protection 65 est ensuite effectuée par photolithographie et gravure localisée, de manière à définir les bras d'isolation thermique 30 dans le plan XY, ainsi que la membrane 60 à thermistance.

En référence à la fig.1B, on réalise ensuite des plots intermédiaires 2 destinés à former des ergots, c'est-à-dire des portions des plots intermédiaires 2 venant chacun en saillie au sein de chaque orifice vertical des piliers de maintien. Pour cela, on dépose tout d'abord une première couche sacrificielle intermédiaire 72.1 de manière à recouvrir le support du pilier de maintien (ici les bras d'isolation thermique 30 et la membrane 60 à thermistance), ainsi que la couche sacrificielle inférieure 71. La couche sacrificielle 72.1 est réalisée en un matériau minéral identique ou similaire à celui de la couche sacrificielle 71.

On réalise ensuite, sur la face supérieure de la première couche sacrificielle intermédiaire 72.1, les plots intermédiaires 2 réalisés en un matériau sensible (c'est-à-dire pouvant être gravé) à l'agent de gravure utilisé ultérieurement pour supprimer les différentes couches sacrificielles. Ce matériau peut être choisi parmi le titane, l'oxyde de tantale Ta₂O₅, un nitrure de silicium déposé de préférence par PECVD à basse température, par exemple à 300°C, entre autres. Ils présentent une épaisseur qui dépend de la nature et de l'épaisseur des couches sacrificielles 72.1, 72.2 à graver, et peut être de l'ordre de quelques dizaines de nanomètres à quelques centaines de nanomètres, par exemple compris entre 100nm et 300nm. Chaque plot intermédiaire 2 est positionné dans le plan XY de sorte qu'une portion soit en saillie dans l'orifice vertical destiné à réaliser le pilier de maintien.

En référence à la fig.iC et 1D, on réalise ensuite les orifices verticaux 51 destinés à former les piliers de maintien creux. Pour cela, on dépose tout d'abord une deuxième couche sacrificielle intermédiaire 72.2 minérale de manière à recouvrir la couche sacrificielle sous-jacente 72.1 ainsi que les plots intermédiaires 2 destinés à former les ergots 2a. L'épaisseur des deux couches sacrificielles intermédiaires 72.1, 72.2 permet de définir la distance séparant l'élément de détection (absorbeur) vis-à-vis de la membrane 60 à thermistance, et ainsi de définir avec la couche sacrificielle 71 la taille de la cavité interférentielle quart d'onde suivant l'axe Z entre l'absorbeur et le réflecteur 40. On peut ensuite recouvrir la deuxième couche sacrificielle intermédiaire 72.2 d'une couche d'arrêt de gravure 81, par exemple réalisée en SiN ou équivalent.

Puis, les orifices verticaux 51 sont réalisés par photolithographie et gravure, et traversent, de haut en bas, la couche d'arrêt de gravure 81 le cas échéant, et les deuxième et première couches sacrificielles intermédiaires 72.2, 72.1, pour déboucher sur le support du pilier de maintien, ici sur la membrane 60 à thermistance. Chaque orifice vertical 51 est délimité transversalement par une bordure latérale 51a, qui s'étend de manière sensiblement parallèle à l'axe Z. Pour obtenir la saillie de chaque ergot 2a vis-à-vis de la bordure latérale 51a de l'orifice vertical 51, et plus précisément sous l'ergot 2a suivant l'axe Z, la gravure des couches sacrificielles intermédiaires 72.1, 72.2 comporte une légère isotropie, en particulier lors de la gravure de la première couche sacrificielle intermédiaire 72.1. La gravure peut être du type RIE (*Reactive Ion Etching,* en anglais). Par ailleurs, les orifices verticaux 51 peuvent présenter une section droite dans le plan (X,Y) de forme carrée, rectangulaire, ou circulaire, d'une surface sensiblement égale, par exemple, à 0,25µm². Ils peuvent présenter une dimension dans le plan XY de l'ordre de 0,5µm environ, et une hauteur comprise entre 0,5µm et 1,5µm environ, par exemple égale à 1µm environ, dans le cadre d'une détection de la gamme infrarouge LWIR.

Du fait du positionnement préalable de chaque plot intermédiaire 2, une portion est alors en saillie vis-à-vis de la bordure latérale 51a de chaque orifice vertical 51. Cette portion forme donc un ergot 2a, c'est-à-dire à une portion en saillie destinée à provoquer une rupture locale de continuité de la couche d'intérêt déposée ultérieurement. De préférence, il est en saillie vis-à-vis de la bordure latérale 51a sur une distance dans le plan XY au moins supérieure à l'épaisseur que la couche d'intérêt est destinée à avoir au niveau de la bordure latérale 51a (formant les parois verticales du pilier de maintien). Ainsi, dans le cas où ces parois verticales sont destinées à présenter une épaisseur moyenne de 50nm environ, l'ergot 2a est alors en saillie sur une distance de préférence au moins égale à 50nm. De préférence, pour préserver la tenue mécanique du pilier de maintien, l'ergot 2a peut s'étendre sur au plus la moitié de la circonférence locale de l'orifice vertical 51.

En référence à la fig.1E, on réalise les piliers de maintien 50 destinés à maintenir suspendu les éléments de détection (ici, les absorbeurs). Pour cela, on dépose une couche d'intérêt 52 de manière à recouvrir la bordure latérale 51a de l'orifice vertical 51 et à venir au contact du support, ici au contact de la membrane 60 à thermistance. La couche d'intérêt 52 est déposée par une technique de dépôt conforme, par exemple par dépôt chimique en phase vapeur (*Chemical Vapor Deposition,* en anglais), voire par dépôt physique en phase vapeur (*Physical Vapor Deposition,* en anglais), par exemple par pulvérisation cathodique (*Sputtering,* en anglais), ou autre. La couche d'intérêt est réalisée en au moins un matériau choisi parmi un siliciure de tungstène WSi, le TiN, le TiW, entre autres.

Les inventeurs ont ainsi constaté que, lorsqu'une telle couche d'intérêt (en WSi, TiN...) est déposée de manière conforme, de préférence par CVD, dans l'orifice vertical 51 dans lequel est en saillie l'ergot 2a, il y a rupture locale de la continuité de la couche d'intérêt 52 sous l'ergot 2a. Il se forme donc une ouverture latérale 54a qui sera mise à profit ultérieurement pour supprimer la couche sacrificielle de remplissage qui sera présente dans l'espace interne 53 du pilier de maintien 50.

De manière à former des piliers de maintien 50 creux, la couche d'intérêt présente une épaisseur inférieure à la dimension latérale de l'orifice vertical 51 dans le plan XY, de sorte que cet orifice vertical 51 n'est pas rempli entièrement par le matériau de la couche d'intérêt 52. A titre d'exemple, la couche d'intérêt 52 peut présenter une épaisseur sensiblement constante de quelques dizaines nanomètres à quelques centaines de nanomètres, par exemple 150nm environ dans un plan XY, et par exemple 50nm dans un plan sensiblement orthogonal au plan XY, alors que l'orifice vertical 51 peut présenter une dimension latérale égale, par exemple, à 0,5µm environ. Aussi, les piliers de maintien 50 sont formés par une couche 52 s'étendant verticalement suivant l'axe Z, hormis au niveau de l'ouverture latérale 54a, qui délimite latéralement un espace interne 53 vide. Cet espace interne 53 débouche sur une ouverture supérieure 54b suivant la direction +Z. Les piliers de maintien 50 comportent donc des parois verticales 50a qui s'étendent sur la bordure latérale 51a de l'orifice vertical 51, reliés entre elles par une paroi inférieure de support 50b, opposée à l'ouverture supérieure 54b et reposant sur et au contact de la membrane 60 à thermistance. Les parois verticales 50a des piliers de maintien 50 s'étendent ici de manière sensiblement orthogonale au plan XY du substrat de lecture 10.

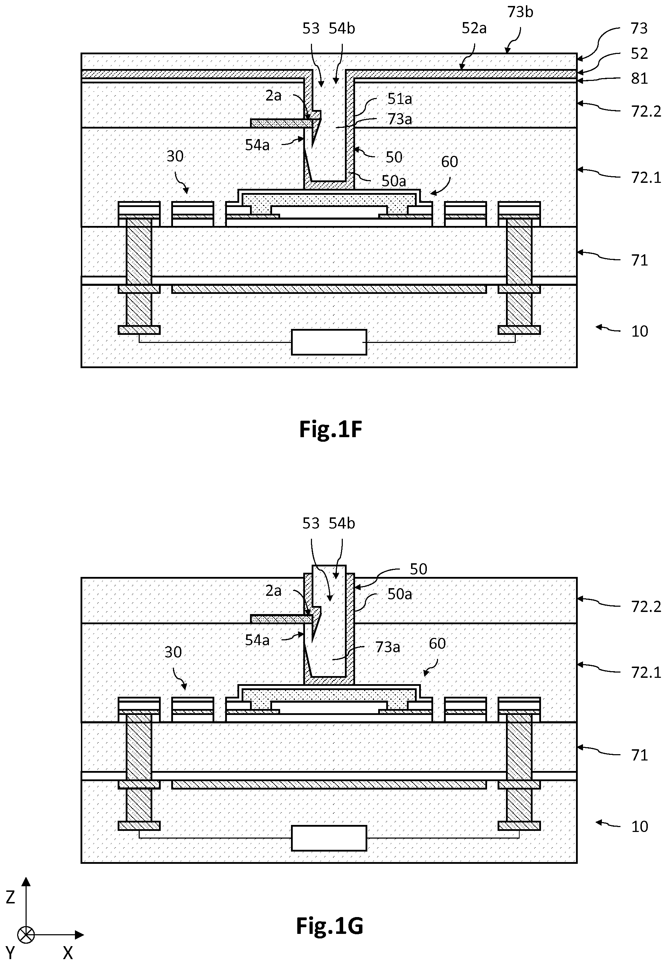

En référence à la fig.1F, on dépose ensuite une couche sacrificielle minérale de remplissage 73, de manière à recouvrir la couche d'intérêt 52 et à remplir l'espace interne 53 des piliers de maintien 50. La couche sacrificielle de remplissage 73 est réalisée de préférence en un matériau diélectrique minéral identique à celui des couches sacrificielles sous-jacentes. Elle comporte une portion supérieure 73b qui recouvre la partie périphérique 52a de la couche d'intérêt 52 qui s'étend sur la couche d'arrêt de gravure 81, et une portion inférieure 73a située dans l'espace interne 53. On obtient ainsi une surface essentiellement plane qui facilite la suite des opérations technologiques.

En référence à la fig.1G, on supprime ensuite la portion supérieure 73b de la couche sacrificielle de remplissage 73 pour exposer la face supérieure de la partie périphérique 52a de la couche d'intérêt 52. Ensuite, par gravure sélective, on supprime la partie périphérique 52a, puis la couche d'arrêt de gravure 81. Ainsi, la face supérieure de la deuxième couche sacrificielle intermédiaire 72.2 est rendue libre (i.e. non recouverte), et la portion inférieure 73a de la couche sacrificielle de remplissage présente une partie en saillie par rapport à la face supérieure libre de la deuxième couche sacrificielle intermédiaire 72.2. L'extrémité supérieure suivant l'axe Z des parois verticales 50a des piliers de maintien 50 est également rendue libre.

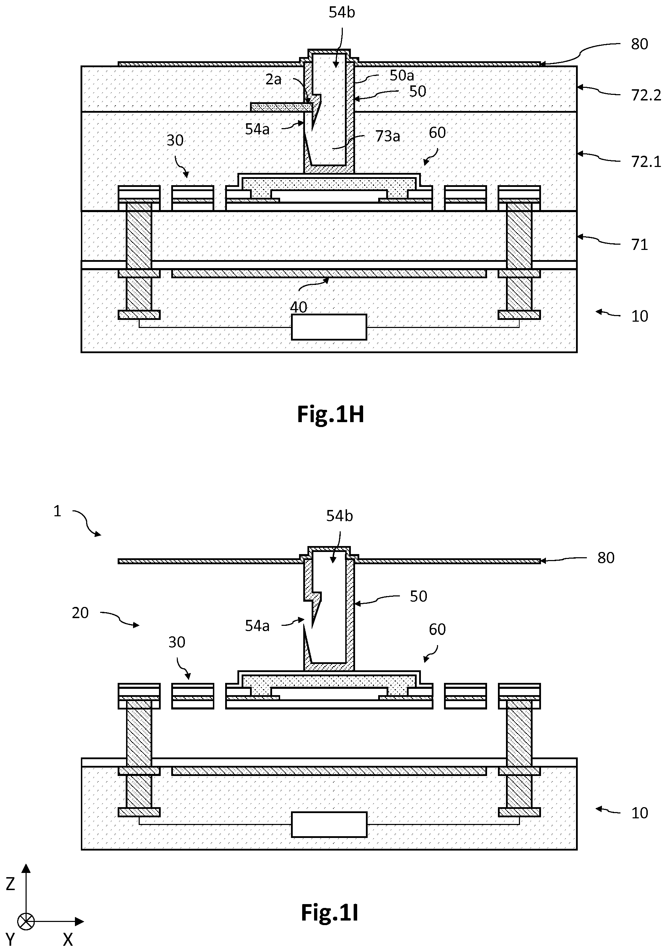

En référence à la fig.1H, on réalise ensuite l'élément de détection de chaque détecteur thermique, à savoir ici l'absorbeur 80. Pour cela, on dépose une couche continue réalisée en un matériau apte à absorber le rayonnement électromagnétique à détecter, de manière à recouvrir la face supérieure de la couche sacrificielle 72.2, l'extrémité libre des parois verticales 50a des piliers de maintien 50, et la portion inférieure 73a de la couche sacrificielle de remplissage. Cette couche peut être recouverte, peut recouvrir, ou être en capsulée dans une couche mince supplémentaire permettant de rigidifier l'absorbeur 80. Cette couche supplémentaire peut être réalisée en un matériau diélectrique, par exemple du silicium amorphe. L'épaisseur de la couche absorbante 80 est choisie de manière à adapter son impédance à celle du vide (résistivité de la couche absorbante proche de 377 Ω/sq). On grave ensuite la couche absorbante de manière localisée, de manière à obtenir ainsi l'absorbeur 80 du détecteur thermique, celui-ci étant ainsi situé au regard du réflecteur 40. Il en ressort que l'absorbeur 80 s'étend de manière continue et sensiblement plane au-dessus du réflecteur 40. Il obture donc l'ouverture supérieure 54b du pilier de maintien 50.

En référence à la fig.1I, on réalise la suspension au-dessus du substrat de lecture 10 de l'absorbeur 80 de chaque détecteur thermique 20, et ici plus largement des structures tridimensionnelles 22. Pour cela, on supprime par gravure chimique les différentes couches sacrificielles minérales 71, 72.1, 72.2, 73. La suspension est plus précisément obtenue par gravure chimique humide en milieu acide des différentes couches sacrificielles minérales, ici à l'acide fluorhydrique en phase vapeur. La portion inférieure 73a de la couche sacrificielle de remplissage 73 est évacuée dans le même temps, au travers de l'ouverture latérale 54a traversante des piliers de maintien 50, et non pas au travers de l'ouverture supérieure 54b, celle-ci étant obturée. Les plots intermédiaires 2 formant les ergots 2a sont également supprimés, dans la mesure où ils sont réalisés en un matériau sensible à l'agent de gravure utilisé, ce qui permet d'éviter qu'ils ne dégradent les performances du dispositif de détection 1 en tombant sur les membranes à matériau thermistance ou en restant fixés aux piliers de maintien 50 (et donc en perturbant le rayonnement électromagnétique dans la cavité optique).

Ainsi, le procédé de fabrication permet d'obtenir un dispositif de détection 1 dont les performances sont optimisées et dont la matrice de pixels sensibles peut présenter un pas pixel particulièrement réduit. En effet, les piliers de maintien 50 sont creux, c'est-à-dire qu'ils ne sont pas remplis par le matériau de la couche d'intérêt 52 ou par celui de la couche sacrificielle de remplissage 73. Ainsi, ils présentent une masse thermique particulièrement réduite, ce qui contribue à diminuer la constante de temps thermique des détecteurs thermiques 20. De plus, l'absorbeur s'étend ici de manière sensiblement plane et présente une surface d'absorption importante, permettant ainsi de former une cavité interférentielle quart d'onde optimisée, ce qui contribue à améliorer les performances du détecteur thermique 20.

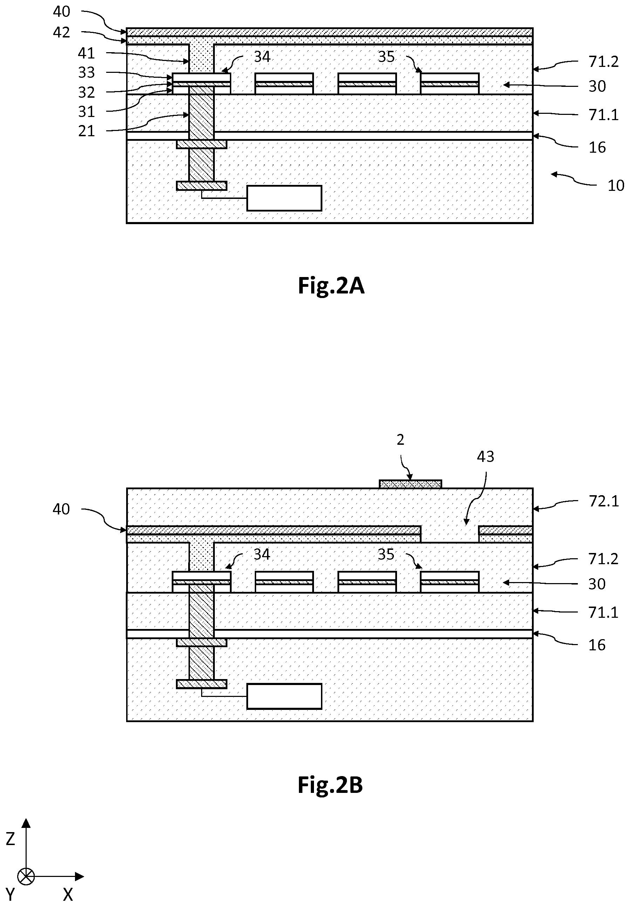

Les figures 2A à 2H illustrent différentes étapes d'un procédé de fabrication du dispositif de détection 1 selon un deuxième mode de réalisation. Le dispositif de détection 1 est similaire à celui illustré sur la fig.1I et s'en distingue essentiellement en ce que l'élément de détection est ici une membrane absorbante 60 à matériau thermistance. Elle est suspendue par un ou plusieurs piliers de maintien 50, qui participent également à connecter le matériau thermistance 64 au circuit de lecture 12. De plus, le réflecteur 40 n'est pas disposé sur et au contact du substrat de lecture 10, mais est situé dans un étage intermédiaire de la structure tridimensionnelle 22.

Plus précisément, le détecteur thermique 20 comporte ici une structure tridimensionnelle 22 à trois étages distincts et superposés les aux autres, suspendus au-dessus du substrat par les piliers d'ancrage 21 : l'étage inférieur comporte les bras d'isolation thermique 30, un étage intermédiaire comporte le réflecteur 40, et un étage supérieur comporte l'élément de détection (ici la membrane absorbante 60 à thermistance), lequel est suspendu par des piliers de maintien 50. Dans cet exemple, les piliers de maintien 50 sont des piliers creux obturés en leurs ouvertures supérieures 54b par la membrane absorbante 60, et comportant chacun une ouverture latérale 54a permettant l'évacuation par le côté d'une couche sacrificielle de remplissage 73 située initialement dans l'espace interne 53 du pilier de maintien 50.

En référence à la fig.2A, on réalise tout d'abord les étages inférieur et intermédiaire de la structure tridimensionnelle. Le substrat de lecture 10 est identique ou similaire à celui décrit en référence à la fig.1A et n'est pas décrit à nouveau en détail. La couche de protection 16 est recouverte par une première couche sacrificielle inférieure 71.1, réalisée en un matériau minéral. Sur la couche sacrificielle 71.1 reposent les bras d'isolation thermique 30, qui s'étendent ici en serpentin entre une première extrémité 34 au contact d'un pilier d'ancrage 21, et une deuxième extrémité 35 destinée à servir de support au pilier de maintien de l'élément de détection (ici la membrane absorbante 60). Les bras d'isolation thermique 30 sont formés d'un empilement d'une couche diélectrique inférieure 31, d'une couche conductrice 32, et d'une couche diélectrique supérieure 33, et sont suspendus au-dessus du substrat de lecture 10 par les piliers d'ancrage 21.

Pour réaliser ensuite l'étage intermédiaire, on dépose une deuxième couche sacrificielle inférieure 71.2 minérale de manière à recouvrir la couche sacrificielle sous-jacente 71.1 ainsi que les bras d'isolation thermique 30. L'épaisseur de la couche sacrificielle 71.2 permet de définir la distance séparant les étages inférieur et intermédiaire de la structure tridimensionnelle, c'est-à-dire le réflecteur 40 vis-à-vis des bras d'isolation thermique 30. Elle peut être de l'ordre de quelques centaines de nanomètres à quelques microns, par exemple comprise entre 500nm et 5µm, et de préférence comprise entre 1µm et 2µm.

On réalise ensuite des orifices verticaux destinés à la formation des plots de maintien 41 du réflecteur 40. Ils sont réalisés par photolithographie et gravure, et traversent la deuxième couche sacrificielle inférieure 71.2, pour déboucher sur les bras d'isolation thermique 30, de préférence sur la première extrémité 34 des bras d'isolation thermique 30 reposant sur les piliers d'ancrage 21, de sorte que les plots de maintien 41 soient de préférence situés en regard des piliers d'ancrage 21. En variante, chaque plot de maintien 41 peut reposer sur et au contact du substrat de lecture 10, et non pas sur un bras d'isolation thermique 30. On dépose ensuite, dans cet exemple, une couche continue de maintien 42, de préférence réalisée en un matériau diélectrique tel que du silicium amorphe, de manière à remplir les orifices verticaux et à recouvrir la deuxième couche sacrificielle inférieure 71.2. La couche de maintien 42 est ensuite recouverte par une couche réflectrice, formant le réflecteur 40, réalisée en un matériau réfléchissant au rayonnement électromagnétique d'intérêt, par exemple une couche métallique réalisée en aluminium, cuivre, tungstène, ou autre. La couche de maintien 42 et le réflecteur 40 peuvent s'étendre de manière continue au niveau de tous les pixels sensibles, ou être distincts d'un pixel sensible à l'autre.

En référence à la fig.2B, on réalise ensuite des plots intermédiaires 2 destinés à former des ergots. Cette étape est ici identique ou similaire à celle décrite précédemment en référence à la fig.iB et n'est pas détaillée à nouveau. Au préalable, on réalise si nécessaire une ouverture traversante 43 par gravure localisée de la couche réflectrice 40 et de la couche de maintien 42 à la perpendiculaire de la partie des bras d'isolation thermique 30 destinée à recevoir le pilier de maintien 50, ici au niveau de la deuxième extrémité 35. Les plots intermédiaires 2 sont réalisés sur la face supérieure d'une première couche sacrificielle intermédiaire 72.1 minérale déposée préalablement sur le réflecteur 40 et sur la couche sacrificielle sous-jacente 71.2 au travers de l'ouverture traversante 43, et sont disposés de manière à former ultérieurement des ergots 2a dans les orifices verticaux 51. Les plots intermédiaires 2 sont réalisés en un matériau sensible à l'agent de gravure utilisé ultérieurement pour supprimer les différentes couches sacrificielles. Comme indiqué précédemment, le matériau peut être choisi parmi le titane Ti, l'oxyde de tantale Ta₂O₅, un nitrure de silicium SiN déposé de préférence par PECVD à basse température, par exemple à 300°C, entre autres. Ils présentent une épaisseur de l'ordre de quelques centaines de nanomètres, par exemple compris entre 100nm et 300nm.

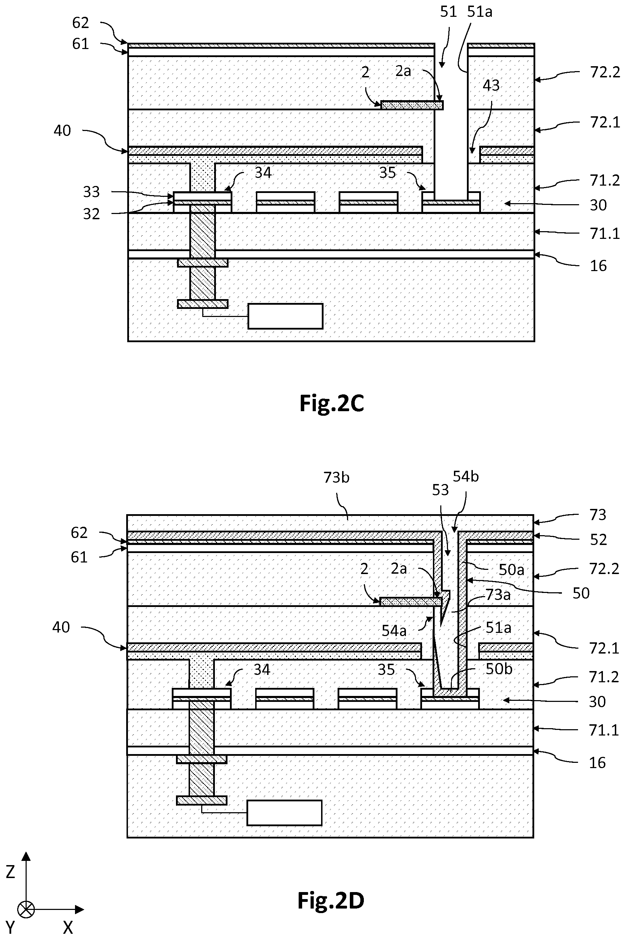

En référence à la fig.2C, on réalise ensuite les orifices verticaux 51 destinés à former les piliers de maintien creux. Pour cela, on dépose tout d'abord une deuxième couche sacrificielle intermédiaire 72.2 minérale, de manière à recouvrir la couche sacrificielle sous-jacente 72.1 ainsi que les plots intermédiaires 2. L'épaisseur des première et deuxième couches sacrificielles intermédiaires 72.1, 72.2 permet de définir la taille de la cavité interférentielle quart d'onde suivant l'axe Z entre les étages intermédiaire et supérieur de la structure tridimensionnelle 22.

On dépose ensuite, sur la face supérieure de la deuxième couche sacrificielle intermédiaire 72.2, la couche diélectrique inférieure 61 de la membrane absorbante 60, ainsi que la couche conductrice 62 destinée à former les électrodes de polarisation. La couche diélectrique inférieure 61 peut être réalisée en au moins un matériau diélectrique. A titre d'exemple, elle peut être formée par exemple d'une sous-couche mince de protection vis-à-vis d'une gravure chimique effectuée ultérieurement, par exemple en silicium amorphe, en Al₂O₃ ou en AlN d'une épaisseur comprise entre 10nm et 50nm, éventuellement revêtue d'une sous-couche de passivation, par exemple en SiN (notamment lorsque la sous-couche mince de protection est en silicium amorphe) d'une épaisseur comprise entre 10nm et 30nm. Le matériau de la couche conductrice 62 est en outre absorbant vis-à-vis du rayonnement électromagnétique à détecter : cette couche conductrice 62 est destinée à former l'absorbeur, en plus des électrodes de polarisation. Elle est réalisée de préférence en Ti, TiN, TaN, WN, ou autre, et présente une épaisseur comprise entre 3nm et 20nm environ. Elle recouvre ici la couche diélectrique inférieure 61.

Puis on réalise les orifices verticaux 51 destinés à la formation des piliers de maintien 50 creux. Ils sont réalisés par photolithographie et gravure, et traversent, de haut en bas, la couche conductrice 62, la couche diélectrique inférieure 61, les deuxième et première couches sacrificielles intermédiaires 72.2, 72.1, et la deuxième couche sacrificielle inférieure 71.2, ainsi que la couche diélectrique supérieure 33, pour déboucher ainsi sur la couche conductrice 32 des bras d'isolation thermique 30, ici au niveau de la deuxième extrémité 35. Pour obtenir la saillie de l'ergot 2a vis-à-vis de la bordure latérale 51a de chaque orifice vertical 51, et plus précisément sous l'ergot 2a suivant l'axe Z, la gravure des couches sacrificielles comporte une légère isotropie, en particulier lors de la gravure de la première couche sacrificielle intermédiaire 72.1 et/ou 71.2.

Comme indiqué précédemment, une portion du plot intermédiaire 2 est alors en saillie vis-à-vis de la bordure latérale 51a de chaque orifice vertical 51. Cette portion forme donc un ergot 2a. L'ergot 2a est de préférence en saillie vis-à-vis de la bordure latérale 51a sur une distance dans le plan XY au moins supérieure à l'épaisseur que la couche d'intérêt 52 est destinée à avoir au niveau de la bordure latérale 51a. Ainsi, dans le cas de parois verticales 50a du pilier de maintien 50 destinées à présenter une épaisseur moyenne de 50nm environ, l'ergot 2a est alors en saillie sur une distance avantageusement au moins égale à 50nm. De préférence, pour préserver la tenue mécanique du pilier de maintien 50, l'ergot 2a peut s'étendre sur au plus la moitié de la circonférence locale de l'orifice vertical.

En référence à la fig.2D, on réalise les piliers de maintien 50 destinés à maintenir suspendues les membranes absorbantes, et à les connecter au circuit de lecture 12. Pour cela, on dépose tout d'abord une couche d'intérêt 52 de manière à recouvrir la bordure latérale 51a de chaque orifice vertical 51 et à venir au contact d'une part de la couche conductrice 32 des bras d'isolation thermique 30, et d'autre part de la couche conductrice 62 destinée à former les électrodes de polarisation. La couche d'intérêt 52 est déposée par une technique de dépôt conforme, par exemple par dépôt chimique en phase vapeur (CVD), voire par dépôt physique en phase vapeur (PVD), par exemple par pulvérisation cathodique, ou autre. Elle est réalisée parmi un matériau ici électriquement conducteur choisi parmi le WSi, le TiN, le TiW, entre autres.

Comme décrit précédemment, le dépôt conforme, de préférence par CVD, d'une telle couche d'intérêt 52 (en WSi, TiN...) dans l'orifice vertical 51 dans lequel est en saillie l'ergot 2a, entraîne une rupture locale de la continuité de la couche d'intérêt 52, notamment sous l'ergot 2a. Il se forme donc une ouverture latérale 54a qui sera mise à profit ultérieurement pour supprimer la couche sacrificielle de remplissage 73 qui sera présente dans l'espace interne 53 du pilier conducteur. Ainsi, les piliers de maintien 50 sont en contact électrique avec le circuit de lecture 12 par l'intermédiaire des piliers d'ancrage 21 et des bras d'isolation thermique 30, et permettent de connecter les électrodes de polarisation 62. Ils comportent des parois verticales 50a reliées entre elles par une paroi inférieure de support 50b, qui repose sur et au contact des bras d'isolation thermique 30. L'espace interne 53 délimitée transversalement par les parois verticales 50a débouche sur une ouverture supérieure 54b opposée à la paroi de support 50b suivant la direction +Z.

Enfin, on dépose une couche sacrificielle minérale de remplissage 73 de manière à recouvrir la couche d'intérêt 52 formant les piliers de maintien 50 et à remplir l'espace interne 53 de ces derniers. La couche sacrificielle 73 est réalisée de préférence en un matériau diélectrique identique à celui des couches sacrificielles sous-jacentes. Elle comporte donc une portion supérieure 73b recouvrant la partie périphérique 52a de la couche d'intérêt 52, et une portion inférieure 73a remplissant l'espace interne 53 des piliers de maintien 50.

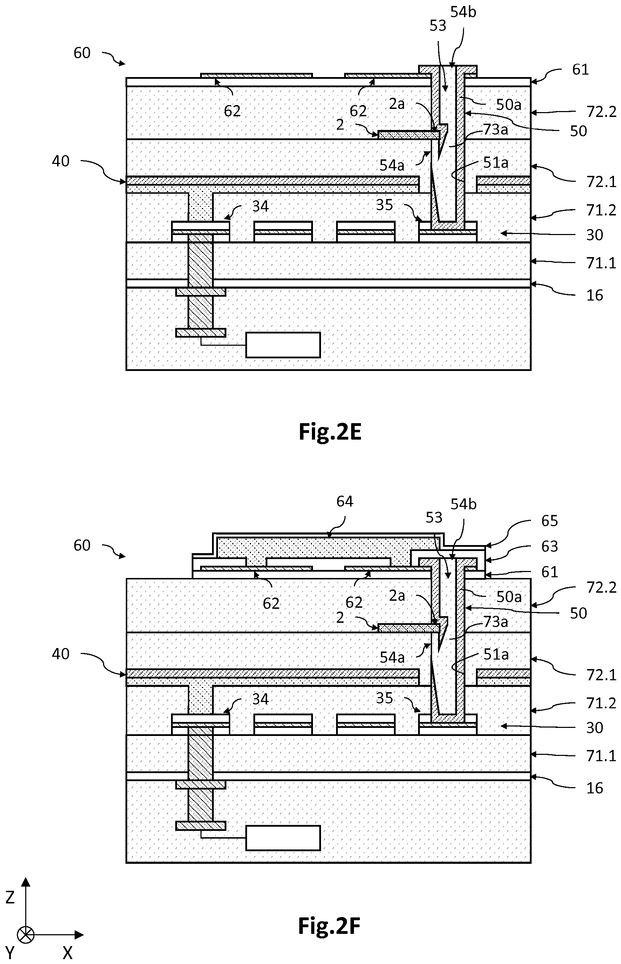

En référence à la fig.2E, on poursuit la réalisation de l'élément de détection, à savoir ici de la membrane absorbante 60 à thermistance qui forme l'étage supérieur de la structure tridimensionnelle 22. Pour cela, on supprime la portion supérieure 73b de la couche sacrificielle de remplissage 73 de manière à exposer la face supérieure de la couche d'intérêt 52. La portion inférieure 73a de la couche sacrificielle de remplissage 73 est ainsi préservée. Elle affleure au niveau de la partie périphérique 52a, parallèle au plan XY, de la couche d'intérêt 52. On obtient ainsi une surface essentiellement plane qui facilite la suite des opérations technologiques (sans quoi il faudrait supprimer les couches qui pourraient tomber dans l'espace interne 53 des piliers de maintien 50).

Ensuite, par photolithographie et gravure, on structure dans le plan XY la couche conductrice 62 de manière à définir les électrodes de polarisation. On grave également la partie périphérique 52a de la couche d'intérêt 52, de manière à n'en garder qu'une portion supérieure au contact des électrodes de polarisation 62. Les électrodes de polarisation 62 sont sensiblement coplanaires et électriquement isolées l'une de l'autre. Elles sont réalisées de manière à présenter une résistivité de l'ordre de 377Ω/sq. Les électrodes de polarisation 62 contactent chacune un pilier de maintien 50 différent et sont séparées l'une de l'autre dans le plan XY d'une distance de préférence inférieure à λ_{c}/5 environ voire inférieure à 1µm. De préférence, le matériau des électrodes 62 est différent de celui de la couche d'intérêt 52, de manière à avoir une sélectivité de gravure entre ces deux matériaux. Ainsi, les électrodes 62 peuvent être réalisées en TiN et la couche d'intérêt 52 peut être réalisée en WSi.

En référence à la fig.2F, on finalise la réalisation de la membrane absorbante 60. Ainsi, par une série d'étapes de dépôt, photolithographie et gravure, on réalise la couche isolante intermédiaire 63 réalisée en un matériau diélectrique, par exemple en Al₂O₃ ou AlN, et recouvrant les électrodes 62 et l'espacement latéral entre celles-ci, hormis au niveau d'ouvertures débouchant sur les électrodes 62. Une portion de matériau thermistance 64, par exemple en silicium amorphe ou en un oxyde de vanadium ou de titane, est déposée au contact électrique des électrodes 62 via les ouvertures. Elle peut présenter une épaisseur par exemple comprise entre 50nm et 200nm. Enfin, une couche supérieure de protection 65, par exemple en silicium amorphe, Al₂O₃ ou AlN d'une épaisseur comprise entre 10nm et 50nm, est déposée de manière à recouvrir le matériau thermistance 64 pour le protéger de l'attaque chimique mise en œuvre ultérieurement.

Ainsi, la membrane absorbante 60 est suspendue par les piliers de maintien 50, qui assurent également la connexion du matériau thermistance 64 au circuit de lecture 12. La membrane absorbante 60, et plus précisément ici la couche diélectrique intermédiaire 63, recouvre l'ouverture supérieure 54b de chaque pilier conducteur. Celle-ci est alors obturée et ne permet pas l'évacuation de la couche sacrificielle de remplissage 73.

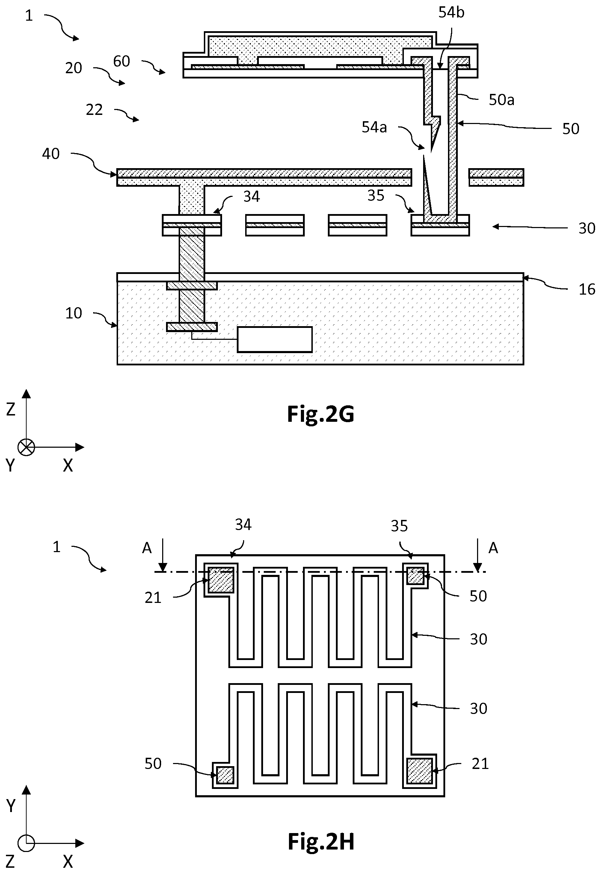

En référence à la fig.2G et 2H, on supprime les couches sacrificielles 71.1, 71.2, 72.1, 72.2,73, de manière à suspendre la structure tridimensionnelle 22 au-dessus du substrat de lecture 10. La suspension est ici obtenue par gravure chimique des différentes couches sacrificielles minérales, ici par une gravure chimique humide par attaque à l'acide fluorhydrique en phase vapeur. La portion inférieure 73a de la couche sacrificielle de remplissage 73 est évacuée dans le même temps, au travers de l'ouverture latérale traversante 54a des piliers de maintien 50, et les plots intermédiaires 2 sont également supprimés dans la mesure où ils sont réalisés en un matériau sensible à l'agent de gravure utilisé, ce qui permet d'éviter qu'ils ne dégradent les performances du dispositif de détection 1.

On obtient ainsi un dispositif de détection 1 comportant ici une matrice de pixels sensibles pouvant présenter un pas pixel particulièrement réduit, chaque pixel sensible ayant une constante de temps réduite. En effet, les piliers de maintien 50 sont creux, ce qui permet de diminuer la masse thermique des piliers de maintien 50 et ainsi de réduire la constante de temps thermique des détecteurs thermiques 20. De plus, le pas pixel peut être particulièrement réduit. Bien que l'ouverture supérieure 54b des piliers de maintien 50 soit obturée par la membrane absorbante 60, la couche sacrificielle de remplissage 73 peut être efficacement évacuée hors de l'espace interne 53 au travers de l'ouverture latérale traversante 54a.

Par ailleurs, ce mode de réalisation du dispositif de détection 1 est particulièrement avantageux dans la mesure où la cavité interférentielle quart d'onde présente des performances optimales. En effet, cet agencement vertical des différents étages fonctionnels d'isolation thermique, de réflexion optique, et d'absorption/détection du rayonnement électromagnétique d'intérêt permet à la fois de réaliser un pixel sensible de petites dimensions latérales dans le plan XY, par exemple de l'ordre d'une dizaine de microns voire moins, tout en optimisant les performances du détecteur thermique 20. En effet, il est possible d'améliorer l'isolation thermique de la membrane absorbante 60 (et donc d'augmenter la résistance thermique du détecteur thermique 20) en réalisant des bras d'isolation thermique 30 d'une longueur importante dans le plan du premier étage dans la mesure où il n'y a pas la contrainte de la présence de la membrane absorbante 60. De plus, le détecteur thermique 20 présente un facteur de remplissage FF important, ce paramètre FF (pour *Fill Factor,* en anglais) étant défini comme le rapport de la surface de la membrane absorbante sur la surface totale du pixel sensible, dans un plan XY parallèle au plan du substrat. Le facteur de remplissage FF est particulièrement important dans la mesure où la membrane absorbante 60 n'est pas limitée en dimensions par la présence des bras d'isolation thermique 30 dans le plan du troisième étage. Aussi, le rendement optique du détecteur thermique 20, produit du paramètre FF par l'absorption ε du détecteur thermique 20 est préservée, l'absorption ε étant définie comme la proportion absorbée par unité de surface de l'énergie incidente du rayonnement électromagnétique à détecter.

De plus, le fait que les bras d'isolation thermique 30 soient situés dans l'étage inférieur et non pas dans l'étage intermédiaire, et donc soient situés en-dehors de la cavité interférentielle quart d'onde, permet de préserver les performances du détecteur thermique 20. En effet, la présence des bras d'isolation thermique 30 dans la cavité interférentielle quart d'onde peut conduire à une perturbation de la cavité interférentielle et en conséquence à une dégradation de l'absorption ε. L'absorbeur 62 de la membrane absorbante 60 est habituellement disposé à une distance du réflecteur 40 telle que l'onde réfléchie génère une interférence constructive avec l'onde incidente au niveau de la membrane absorbante 60, c'est-à-dire à une distance sensiblement égale à λ_{c}/4n du réflecteur, λ_{c} étant une longueur d'onde centrale de la gamme spectrale du rayonnement électromagnétique à détecter (par exemple 10µm pour la gamme LWIR), et n étant l'indice de réfraction du milieu situé dans la cavité interférentielle quart d'onde, habituellement le vide. Or, la présence des bras d'isolation thermique 30 au sein de la cavité interférentielle quart d'onde peut entraîner une diminution de l'absorption ε du détecteur thermique 20 du fait d'une modification du chemin optique permettant de générer une interférence constructive au niveau de la membrane absorbante d'une part, et du fait d'une absorption non nulle du rayonnement électromagnétique par les bras d'isolation thermique 30 d'autre part. Il en ressort que ces inconvénients sont ici écartés dans la mesure où les bras d'isolation thermique 30 sont disposés en dehors de la cavité interférentielle quart d'onde. Les performances du détecteur thermique 20 sont alors préservées.

Des modes de réalisation particuliers viennent d'être décrits. Différentes variantes et modifications apparaîtront à l'homme du métier.

## Revendications

1. Procédé de fabrication d'un dispositif de détection (1) d'un rayonnement électromagnétique, le dispositif de détection (1) comportant :
- un substrat (10) comportant un circuit de lecture (12) ;
- au moins un détecteur thermique (20) reposant sur le substrat (10), et connecté au circuit de lecture (12), comportant un élément de détection (80 ; 60) suspendu au-dessus du substrat (10) par au moins un pilier de maintien (50) ;
le procédé comportant les étapes suivantes :
∘ dépôt, sur le substrat (10), d'une première couche sacrificielle (72.1) ;
∘ réalisation, sur la première couche sacrificielle (72.1), d'au moins un plot intermédiaire (2) destiné à former un ergot (2a), le plot intermédiaire (2) étant réalisé en au moins un matériau sensible à un agent de gravure chimique utilisé ultérieurement lors de la gravure de couches sacrificielles (71, 72.1, 72.2, 73) ;
∘ dépôt, sur la première couche sacrificielle (72.1) et le plot intermédiaire (2), d'une deuxième couche sacrificielle (72.2) ;
∘ réalisation, par gravure localisée des première et deuxième couches sacrificielles (72.1, 72.2), d'au moins un orifice vertical (51) délimité transversalement par une bordure latérale (51a), positionné de sorte qu'une portion du plot intermédiaire (2) soit en saillie dans l'orifice vertical (51), formant ainsi un ergot (2a) ;
∘ dépôt conforme, sur la bordure latérale (51a) de l'orifice vertical (51), d'une couche d'intérêt (52) destinée à former le pilier de maintien (50), laquelle définit alors un espace interne vide (53) du pilier de maintien (50), l'ergot (2a) entraînant une rupture locale de continuité de la couche d'intérêt (52), formant une ouverture latérale traversante (54a) du pilier de maintien (50) ;
∘ dépôt d'une couche sacrificielle de remplissage (73), de manière à remplir l'espace interne vide (53) du pilier de maintien (50) ;
∘ réalisation, sur la deuxième couche sacrificielle (72.2) et la couche sacrificielle de remplissage (73), de l'élément de détection (80 ; 60) qui repose sur et au contact du pilier de maintien (50) ;
∘ suspension de l'élément de détection (80 ; 60), par gravure desdites couches sacrificielles (72.1, 72.2, 73) et du plot intermédiaire (2) par ledit agent de gravure, la couche sacrificielle de remplissage (73) étant alors gravée au travers de l'ouverture latérale traversante (54a).

2. Procédé de fabrication selon la revendication 1, dans lequel l'espace interne (53) du pilier de maintien (50) débouche sur une ouverture supérieure (54b) située de manière opposée au substrat (10), ladite ouverture supérieure (54b) étant obturée par l'élément de détection (80 ; 60).

3. Procédé de fabrication selon la revendication 1 ou 2, dans lequel la couche d'intérêt (52) présente, au niveau de la bordure latérale (51a) de l'orifice vertical (51), une épaisseur moyenne (e_{moy}), l'ergot (2a) présentant une saillie vis-à-vis de la bordure latérale (51a) d'une distance au moins égale à ladite épaisseur moyenne.

4. Procédé de fabrication selon l'une quelconque des revendications 1 à 3, dans lequel le plot intermédiaire (2) est réalisé en un matériau choisi parmi le Ti, le Ta₂O₅, et un nitrure de silicium.

5. Procédé de fabrication selon l'une quelconque des revendications 1 à 4, dans lequel la couche d'intérêt (52) est déposée par dépôt chimique en phase vapeur.

6. Procédé de fabrication selon l'une quelconque des revendications 1 à 5, dans lequel la couche d'intérêt (52) est réalisée en un matériau choisi parmi le WSi, le TiN et le TiW.

7. Procédé de fabrication selon l'une quelconque des revendications 1 à 6, dans lequel les couches sacrificielles (72.1, 72.2, 73) sont réalisées en un matériau minéral, et sont supprimées par gravure chimique humide en milieu acide.

8. Procédé de fabrication selon l'une quelconque des revendications 1 à 7, dans laquelle, à la suite de l'étape de dépôt de la couche sacrificielle de remplissage (73), celle-ci comporte une portion supérieure (73b) qui recouvre une partie périphérique (52a) de la couche d'intérêt (52) qui recouvre une face supérieure de la deuxième couche sacrificielle (72.2) autour de l'orifice vertical (51), et une portion inférieure (73a) qui remplit l'espace interne (53) du pilier de maintien (50).

9. Procédé de fabrication selon la revendication 8, comportant une étape de suppression de la portion supérieure (73b) de la couche sacrificielle de remplissage (73), de sorte que la portion inférieure (73a) affleure au niveau de la partie périphérique (52a) de la couche d'intérêt (52).

10. Procédé de fabrication selon l'une quelconque des revendications 1 à 9, dans lequel l'élément de détection est un absorbeur (80) du rayonnement électromagnétique à détecter, le pilier de maintien (50) reposant sur et au contact d'une membrane (60) comportant un transducteur thermométrique (64) et suspendue au-dessus du substrat (10) par des bras d'isolation thermique (30), un réflecteur (40) reposant sur et au contact du substrat (10).

11. Procédé de fabrication selon l'une quelconque des revendications 1 à 9, dans lequel l'élément de détection est une membrane absorbante (60) du rayonnement électromagnétique à détecter et comportant un transducteur thermométrique (64), le pilier de maintien (50) reposant sur et au contact d'un bras d'isolation thermique suspendu au-dessus du substrat (10) par un pilier d'ancrage (21), un réflecteur (40) étant disposé entre la membrane absorbante (60) et le bras d'isolation thermique (30).

## Patentansprüche

1. Verfahren zur Herstellung einer Erfassungsvorrichtung (1) einer elektromagnetischen Strahlung, wobei die Erfassungsvorrichtung (1) aufweist:
- ein eine Leseschaltung (12) aufweisendes Substrat (10);
- mindestens einen thermischen Detektor (20), der auf dem Substrat (10) aufliegt und mit der Leseschaltung (12) verbunden ist, der ein Erfassungselement (80; 60) aufweist, das oberhalb des Substrats (10) durch mindestens eine Haltesäule (50) aufgehängt ist;
wobei das Verfahren die folgenden Schritte aufweist:
o Aufbringen einer ersten Opferschicht (72.1) auf das Substrat (10);
o Herstellung auf der ersten Opferschicht (72.1) mindestens eines Zwischenblocks (2), der dazu bestimmt ist, einen Zapfen (2a) zu bilden, wobei der Zwischenblock (2) aus mindestens einem Material hergestellt wird, das für ein chemisches Ätzmittel empfindlich ist, das später beim Ätzen von Opferschichten (71, 72.1, 72.2, 73) verwendet wird;
o Aufbringen einer zweiten Opferschicht (72.2) auf die erste Opferschicht (72.1) und den Zwischenblock (2);
o Herstellung, durch lokalisiertes Ätzen der ersten und zweiten Opferschichten (72.1, 72.2), mindestens einer in Querrichtung durch eine seitliche Randleiste (51a) begrenzten senkrechten Öffnung (51), die so positioniert ist, dass ein Abschnitt des Zwischenblocks (2) in die senkrechte Öffnung (51) vorsteht, wodurch ein Zapfen (2a) gebildet wird;
o entsprechendes Aufbringen, auf die seitliche Randleiste (51a) der senkrechten Öffnung (51), einer zur Bildung der Haltesäule (50) bestimmten interessierenden Schicht (52), die dann einen leeren Innenraum (53) der Haltesäule (50) bildet, wobei der Zapfen (2a) eine lokale Kontinuitätsunterbrechung der interessierenden Schicht (52) bewirkt, die eine seitliche Durchgangsöffnung (54a) der Haltesäule (50) bildet;
o Aufbringen einer Füll-Opferschicht (73), um den leeren Innenraum (53) der Haltesäule (50) zu füllen;
o Herstellung auf der zweiten Opferschicht (72.2) und der Füll-Opferschicht (73) des Erfassungselements (80; 60), das auf und in Kontakt mit der Haltesäule (50) aufliegt;
o Aufhängen des Erfassungselements (80; 60) durch Ätzen der Opferschichten (72.1, 72.2, 73) und des Zwischenblocks (2) mit dem Ätzmittel, wobei die Füll-Opferschicht (73) dann durch die seitliche Durchgangsöffnung (54a) hindurch geätzt wird.

2. Herstellungsverfahren nach Anspruch 1, wobei der Innenraum (53) der Haltesäule (50) an einer oberen Öffnung (54b) mündet, die sich entgegengesetzt zum Substrat (10) befindet, wobei die obere Öffnung (54b) vom Erfassungselement (80; 60) verschlossen wird.

3. Herstellungsverfahren nach Anspruch 1 oder 2, wobei die interessierende Schicht (52) im Bereich der seitlichen Randleiste (51a) der senkrechten Öffnung (51) eine mittlere Dicke (e_{moy}) aufweist, wobei der Zapfen (2a) einen Vorsprung gegenüber der seitlichen Randleiste (51a) um einen Abstand mindestens gleich der mittleren Dicke aufweist.

4. Herstellungsverfahren nach einem der Ansprüche 1 bis 3, wobei der Zwischenblock (2) aus einem Material hergestellt wird, das ausgewählt wird aus Ti, Ta₂O₅ und einem Siliciumnitrid.

5. Herstellungsverfahren nach einem der Ansprüche 1 bis 4, wobei die interessierende Schicht (52) durch chemische Dampfabscheidung aufgebracht wird.

6. Herstellungsverfahren nach einem der Ansprüche 1 bis 5, wobei die interessierende Schicht (52) aus einem Material hergestellt wird, das ausgewählt wird aus WSi, TiN und TiW.

7. Herstellungsverfahren nach einem der Ansprüche 1 bis 6, wobei die Opferschichten (72.1, 72.2, 73) aus einem mineralischen Material hergestellt werden und durch nasschemisches Ätzen in saurem Medium entfernt werden.

8. Herstellungsverfahren nach einem der Ansprüche 1 bis 7, bei dem nach dem Schritt des Aufbringens der Füll-Opferschicht (73) diese einen oberen Abschnitt (73b), der einen Umfangsteil (52a) der interessierenden Schicht (52) bedeckt, die eine Oberseite der zweiten Opferschicht (72.2) um die senkrechte Öffnung (51) herum bedeckt, und einen unteren Abschnitt (73a) aufweist, der den Innenraum 53) der Haltesäule (50) füllt.

9. Herstellungsverfahren nach Anspruch 8, das einen Schritt des Entfernens des oberen Abschnitts (73b) der Füll-Opferschicht (73) aufweist, so dass der untere Abschnitt (73a) im Bereich des Umfangteils (52a) der interessierenden Schicht (52) bündig anliegt.

10. Herstellungsverfahren nach einem der Ansprüche 1 bis 9, wobei das Erfassungselement ein Absorber (80) der zu erfassenden elektromagnetischen Strahlung ist, wobei die Haltesäule (50) auf und in Kontakt mit einer Membran (60) aufliegt, die einen thermometrischen Wandler (64) aufweist und oberhalb des Substrats (10) durch Wärmeisolationsarme (30) aufgehängt ist, wobei ein Reflektor (40) auf und in Kontakt mit dem Substrat (10) aufliegt.

11. Herstellungsverfahren nach einem der Ansprüche 1 bis 9, wobei das Erfassungselement eine absorbierende Membran (60) der zu erfassenden elektromagnetischen Strahlung ist und einen thermometrischen Wandler (64) aufweist, wobei die Haltesäule (50) auf und in Kontakt mit einem Wärmeisolationsarm aufliegt, der oberhalb des Substrats (10) durch eine Verankerungssäule (21) aufgehängt ist, wobei ein Reflektor (40) zwischen der absorbierenden Membran (60) und dem Wärmeisolationsarm (30) angeordnet ist.

## Claims

1. Process for fabricating a device (1) for detecting electromagnetic radiation, the detecting device (1) comprising:
- a substrate (10) comprising a readout circuit (12);
- at least one thermal detector (20) resting on the substrate (10), and connected to the readout circuit (12), comprising a detecting element (80; 60) suspended above the substrate (10) by at least one supporting pillar (50);
the process comprising the following steps:
o depositing, on the substrate (10), a first sacrificial layer (72.1);
o producing, on the first sacrificial layer (72.1), at least one intermediate pad (2) intended to form a jut (2a), the intermediate pad (2) being made of at least one material sensitive to a chemical etchant used subsequently to etch sacrificial layers (71, 72.1, 72.2, 73);
o depositing, on the first sacrificial layer (72.1) and the intermediate pad (2), a second sacrificial layer (72.2);
o producing, by locally etching the first and second sacrificial layers (72.1, 72.2), at least one vertical orifice (51) that is bounded transversely by a lateral border (51a), said orifice being positioned so that a segment of the intermediate pad (2) protrudes into the vertical orifice (51), thus forming a jut (2a);
o carrying out conformal deposition, on the lateral border (51a) of the vertical orifice (51), of a layer of interest (52) that is intended to form the supporting pillar (50), which layer of interest then defines an empty internal space (53) of the supporting pillar (50), the jut (2a) causing a local break in the continuity of the layer of interest (52), forming a lateral through-aperture (54a) in the supporting pillar (50);
o depositing a sacrificial filling layer (73), so as to fill the empty internal space (53) of the supporting pillar (50);
o producing, on the second sacrificial layer (72.2) and the sacrificial filling layer (73), the detecting element (80; 60), which rests on and in contact with the supporting pillar (50);
o suspending the detecting element (80; 60), by etching said sacrificial layers (72.1, 72.2, 73) and the intermediate pad (2) using said etchant, the sacrificial filling layer (73) then being etched through the lateral through-aperture (54a).

2. Fabricating process according to Claim 1, wherein the internal space (53) of the supporting pillar (50) opens onto an upper aperture (54b) located opposite the substrate (10), said upper aperture (54b) being obturated by the detecting element (80; 60).

3. Fabricating process according to Claim 1 or 2, wherein the layer of interest (52) has, on the lateral border (51a) of the vertical orifice (51), an average thickness (e_{moy}), the jut (2a) protruding with respect to the lateral border (51a) by a distance at least equal to said average thickness.

4. Fabricating process according to any one of Claims 1 to 3, wherein the intermediate pad (2) is made of a material chosen from Ti, Ta₂O₅, and a silicon nitride.

5. Fabricating process according to any one of Claims 1 to 4, wherein the layer of interest (52) is deposited by chemical vapor deposition.

6. Fabricating process according to any one of Claims 1 to 5, wherein the layer of interest (52) is made of a material chosen from WSi, TiN and TiW.

7. Fabricating process according to any one of Claims 1 to 6, wherein the sacrificial layers (72.1, 72.2, 73) are made of a mineral material, and are removed by wet chemical etching in an acidic medium.

8. Fabricating process according to any one of Claims 1 to 7, wherein, following the step of depositing the sacrificial filling layer (73), the latter comprises an upper segment (73b) that covers a peripheral segment (52a) of the layer of interest (52), which covers an upper face of the second sacrificial layer (72.2) around the vertical orifice (51), and a lower segment (73a) that fills the internal space (53) of the supporting pillar (50).

9. Fabricating process according to Claim 8, comprising a step of removing the upper segment (73b) of the sacrificial filling layer (73), so that the lower segment (73a) is flush with the peripheral portion (52a) of the layer of interest (52).

10. Fabricating process according to any one of Claims 1 to 9, wherein the detecting element is an absorber (80) of the electromagnetic radiation to be detected, the supporting pillar (50) resting on and in contact with a membrane (60) that comprises a thermometric transducer (64) and that is suspended above the substrate (10) by thermally insulating arms (30), a reflector (40) resting on and in contact with the substrate (10).

11. Fabricating process according to any one of Claims 1 to 9, wherein the detecting element is an absorbent membrane (60) that absorbs the electromagnetic radiation to be detected and that comprises a thermometric transducer (64), the supporting pillar (50) resting on and in contact with a thermally insulating arm suspended above the substrate (10) by an anchoring pillar (21), a reflector (40) being placed between the absorbent membrane (60) and the thermally insulating arm (30).
